# EUROPÄISCHE PATENTSCHRIFT

(11) **EP 0 874 281 B1**
(45) Veröffentlichungstag und Bekanntmachung des Hinweises auf die Patenterteilung: **04.12.2002**
(21) Anmeldenummer: 98106609.5
(22) Anmeldetag: 09.04.1998
(51) Int. Cl.: G03F 7/004, G03F 7/039

(54) **Chemisch verstärkter Resist**
Chemically amplified resist
Réserve chimiquement amplifiée

(30) Priorität: 23.04.1997 DE 19717157
(43) Veröffentlichungstag der Anmeldung: 28.10.1998
(73) Patentinhaber: Infineon Technologies AG, 81669 München (DE)
(72) Erfinder: Leuschner, Rainer, Dr., 91091 Grossenseebach (DE); Günther, Ewald, Dr., 91074 Herzogenaurach (DE); Elian, Klaus, Dr., 91058 Erlangen (DE)
(74) Vertreter: Epping Hermann & Fischer

(56) Entgegenhaltungen:
- EP-A- 0 492 256
- EP-A- 0 494 383
- EP-A- 0 611 998
- EP-A- 0 701 171

## Beschreibung

Die Erfindung betrifft einen chemisch verstärkten Resist.

In der Mikroelektronik werden im großen Umfang sogenannte chemisch verstärkte Resists ("chemically amplified resists") für die optische Lithographie und das Elektronenstrahlschreiben eingesetzt (siehe dazu: "Solid State Technology", Vol. 34 (1991), No. 8, Seiten 53 bis 60). Die chemische Verstärkung findet sowohl bei naßentwickelbaren Einlagenresists Anwendung als auch bei ganz oder teilweise trockenentwickelbaren Resists. Die Resists können dabei nach dem Prinzip der säurekatalytischen Spaltung arbeiten, wobei polare, aber blockierte chemische Gruppen, beispielsweise Carboxylgruppen oder phenolische Hydroxylgruppen durch eine photolytisch erzeugte Säure deblockiert werden und der Resist in den belichteten Bereichen seine Polarität ändert. Diese Polaritätsänderung kann beispielsweise zur Entwicklung des Resists in einem basischen Entwickler oder - bei trockenentwickelbaren Resists - für eine selektive Silylierung genutzt werden. Beispiele für blockierende Gruppen sind tert.-Butylester- und tert.-Butoxycarbonyloxygruppen.

Aus der EP-OS 0 492 256 ist eine photolithographische Strukturerzeugung bekannt, bei der ein trockenentwickelbarer Resist nach der Belichtung einer Temperaturbehandlung (Post Exposure Bake = PEB) unterworfen, dann aus flüssiger Phase silyliert und anschließend im Sauerstoffplasma anisotrop geätzt bzw. trocken entwickelt wird. Je nach der Art der Silylierungslösung werden dabei positive oder negative Strukturen (Bilder) erzeugt. Der Resist besteht im allgemeinen mindestens aus zwei festen Bestandteilen, d.h. aus einem Basispolymer und einem photoaktiven Säurebildner. Das Basispolymer enthält Carbonsäureanhydrid- und tert.-Butylester-Partialstrukturen, der Säurebildner ist vorzugsweise eine Oniumverbindung, wie Diphenyljodonium- und Triphenylsulfonium-trifluormethansulfonat. Ein derartiger Resist eignet sich insbesondere für die Photostrukturierung im Submikron- und Subhalbmikronbereich mit sehr steilen Flanken.

Bei einer Strukturerzeugung in der vorstehend geschilderten Weise wurde - ebenso wie bei anderen bekannten Resistsystemen, welche nach dem Prinzip der säurekatalytischen Spaltung arbeiten - der sogenannte Standzeit-Effekt ("delay time effect") festgestellt. Wenn nämlich die Zeitspanne ("delay time") zwischen der Belichtung und der Temperaturbehandlung (PEB) einen bestimmten Wert übersteigt, dann treten deutliche Abweichungen zwischen der nominalen Strukturdimension (Strukturgröße auf der Maske) und der abgebildeten Struktur (Strukturgröße im Resist nach der Entwicklung) auf. Je länger diese Zeitspanne ist, um so größer sind die Abweichungen. Ab einem bestimmten Wert für die Zeitspanne, bei anhydridgruppenhaltigen Resists der vorstehend genannten Art beispielsweise ca. 30 min, sind nach der Entwicklung kaum noch Strukturen erkennbar. Die tolerable Zeitspanne beträgt bei diesen Resists ca. 5 bis 10 min. Eine derartig kurze Zeitspanne kann aus produktionstechnischen Gründen jedoch nicht akzeptiert werden.

Das geschilderte Problem ist allgemein bekannt und wird auf basische Kontaminationen in der Luft zurückgeführt, die während der Standzeit die photochemisch erzeugte starke Säure desaktivieren. Deshalb wurde bereits vorgeschlagen, dieses Problem durch Filtration der Luft mittels Aktivkohle zu lösen (siehe: "Proceedings SPIE", Vol. 1466 (1991), Seiten 2 bis 12). Dies erfordert aber hohe Investitionen.

Auch durch andere Maßnahmen, beispielsweise durch Zusatz von Additiven, konnte der Standzeit-Effekt nicht entscheidend abgeschwächt werden (siehe: "Proceedings SPIE", Vol. 1466 (1991), Seiten 13 bis 25). Eine Verlängerung der Standzeit ist zwar durch Aufbringen einer zusätzlichen Schicht möglich, aber nur im geringen Ausmaß. Außerdem stellt diese Maßnahme einen zusätzlichen Prozeßschritt dar, was aber in der Produktion unerwünscht ist, weil es zu Ausbeuteverlusten führt.

Für Strukturabmessungen < 0,25 µm, die eine zunehmende Bedeutung erlangen, ist eine während der Zeitspanne zwischen Belichtung und PEB erfolgende Diffusion der durch die Belichtung erzeugten Photosäure störend. Die Säure diffundiert nämlich von belichteten Bereichen in unbelichtete, so daß auch diese Bereiche löslich werden, was aber unerwünscht ist. Außerdem können basische Verunreinigungen in belichtete Bereiche eindiffundieren und dort die Photosäure desaktivieren. Beide Effekte führen aber dazu, daß Strukturabmessungen, die im Bereich der Diffusionslänge liegen, nicht mehr zuverlässig erzeugt werden können.

Die lateralen Diffusionseffekte können durch keine der vorstehend genannten Maßnahmen reduziert werden. Eine Reduzierung der Diffusion kann zwar durch die Erzeugung eines dichteren Polymergefüges - aufgrund einer erhöhten Temperatur beim Verdampfen des Lösemittels aus der Resistlösung - erfolgen (siehe: "Journal of Photopolymer Science and Technology", Vol. 8 (1995), No. 4, Seiten 643 bis 652), diese Maßnahme erfordert allerdings spezielle Polymere mit niedriger Glasübergangstemperatur und ist deshalb nicht generell anwendbar.

Aufgabe der Erfindung ist es, bei chemisch verstärkten, anhydridgruppenhaltigen Resists, welche die Möglichkeit einer Silylierung aus flüssiger Phase bieten, das Standzeitproblem ohne zusätzliche Prozeßschritte oder Investitionen zu lösen, d.h. die Standzeit zwischen Belichtung bzw. Elektronenbestrahlung und Temperaturbehandlung (von einem Wert von ca. 10 min) auf ein produktionstechnisch akzeptables Niveau, nämlich ≥ 8 h, zu erhöhen; gleichzeitig soll der Resist aber eine hohe Auflösung ermöglichen und eine hohe Empfindlichkeit (möglichst geringe Belichtungs- bzw. Bestrahlungsdosis und möglichst niedrige PEB-Temperatur) aufweisen.

Dies wird erfindungsgemäß dadurch erreicht, daß der Resist folgende Komponenten enthält:
- ein Polymer mit Carbonsäureanhydridgruppen und tert.-Butylester-, tert.-Butoxycarbonyloxy-, Tetrahydrofuranyloder Tetrahydropyranylgruppen,
- eine photoreaktive Verbindung, die bei Belichtung oder Elektronenbestrahlung eine Sulfonsäure mit einem pKₐ-Wert > 0,5 freisetzt (Säurebildner),
- eine Verbindung, die mit der Sulfonsäure eine reversible chemische Reaktion eingehen kann (Pufferverbindung), und
- ein Lösemittel.

Vorteilhaft, insbesondere für eine Belichtung, enthält der Resist ferner einen Sensibilisator, der eine Erhöhung der Licht- bzw. Elektronenausbeute bewirkt.

Die Erfindung löst das Standzeitproblem durch folgende ineinandergreifende Maßnahmen:
1. Für den Resist (auf der Basis von Polymeren der vorstehend genannten Art) dient als Säurebildner eine photoreaktive Verbindung, aus der eine relativ schwache Sulfonsäure (pKₐ > 0,5 bis 4) freigesetzt wird, beispielsweise Benzolsulfonsäure (pKₐ = 0,70) und Toluolsulfonsäure (pKₐ = 1,55); pKₐ ist der sogenannte Säureexponent (negativer dekadischer Logarithmus der Säurekonstante Kₐ). Eine derartige Säure hat den Vorteil, daß sie gegenüber basischen Verunreinigungen relativ unempfindlich ist und daß der Dampfdruck und die Beweglichkeit deutlich geringer sind als bei der sonst häufig eingesetzten Trifluormethansulfonsäure (pKₐ = -5,9).
2. Der Resist enthält eine sogenannte Pufferverbindung. Dies ist eine Verbindung, die mit der bei der Belichtung bzw. Elektronenbestrahlung gebildeten Sulfonsäure eine reversible chemische Reaktion eingehen kann, d.h. eine Säure-Base-Gleichgewichtsreaktion. Die Pufferverbindung fängt dabei einen Teil der Säure ab und für den Fall, daß Basen eindiffundieren, gibt sie wieder Protonen ab.
3. Vorteilhaft enthält der Resist ferner einen Sensibilisator. Auf diese Weise wird verhindert, daß durch die relativ schwache Säure und durch die Wirkung der Pufferverbindung als Säurefänger die Resistempfindlichkeit zu gering wird. Der Sensibilisator erhöht nämlich die Lichtausbeute bzw. die Wechselwirkung mit den Elektronenstrahlen. Bei einem Zweilagenresist oder einem sogenannten TSI-Resist (TSI = Top Surface Imaging) kann im übrigen die Lichtabsorption höher sein als bei einem normalen Einlagenresist, da nur eine sehr dünne Schicht belichtet werden muß.

Durch die genannten Maßnahmen - spezieller Säurebildner, Pufferverbindung und gegebenenfalls Sensibilisator - ist der Resist nach der Erfindung, der ein Positivresist ist, bei guter Empfindlichkeit (< 10 mJ/cm² bei PEB-Temperaturen ≤ 100°C) sehr unempfindlich gegenüber basischen Verunreinigungen aus der Atmosphäre, die eine Hauptursache für den Standzeiteffekt darstellen. Die Standzeit wird deshalb auf 24 h und mehr erhöht.

Aus der WO 96/08751 ist ein Verfahren zur photolithographischen Strukturerzeugung bekannt, das unter anderem nach der Zweilagenresisttechnik arbeitet. Dabei wird ein naßentwickelbarer Topresist auf der Basis eines Polymers eingesetzt, das Carbonsäureanhydridgruppen und tert.-Butylester- oder tert.-Butoxycarbonyloxygruppen aufweist. Neben dem Polymer enthält der Resist eine photoaktive Komponente in Form eines Esters einer Naphthochinondiazid-4-sulfonsäure mit einer aromatischen Hydroxyverbindung spezieller Struktur. Im Vergleich zu diesem Resist weist der Resist nach der Erfindung eine höhere Empfindlichkeit auf, d.h. die bei der Belichtung erforderliche Energie ist geringer, und der PEB-Schritt erfolgt bei niedrigeren Temperaturen (8 mJ/cm² bei 100°C im Vergleich zu 19 mJ/cm² bei 140°C). Außerdem ist die Standzeit beträchtlich verlängert (von 16 h auf mindestens 24 h), was insbesondere auch für kleine Strukturen (< 0,4 µm) gilt.

Dem Resist nach der Erfindung liegt ein Polymer zugrunde, das - neben Anhydridgruppen - tert.-Butylester-, tert.-Butoxycarbonyloxy-, Tetrahydrofuranyl- oder Tetrahydropyranylgruppen aufweist. Bevorzugt werden dabei solche Polymere, deren Carbonsäureanhydridgruppen sich von Maleinsäureanhydrid ableiten. Eine andere derartige Verbindung ist beispielsweise Itaconsäureanhydrid. Den tert.-Butylestergruppen liegt vorzugsweise Acrylsäure-, Methacrylsäure-, Vinylbenzoesäureoder Zimtsäure-tert.-butylester zugrunde, den tert.-Butoxycarbonyloxygruppen vorzugsweise tert.-Butoxycarbonyloxystyrol oder -maleinimid. Außer Copolymeren können im Resist auch Terpolymere Verwendung finden, beispielsweise Terpolymere aus Maleinsäureanhydrid, Methacrylsäure-tert.-butylester und Methacrylsäure (als dritte Komponente).

Als Säurebildner dienen photoreaktive Verbindungen, die eine schwache Sulfonsäure freisetzen. Dies sind vorteilhaft folgende Verbindungen: Sulfonate, insbesondere von aromatischen Sulfonsäuren, mit einem Diphenyljodonium- oder Triphenylsulfoniumkation, Disulfone und Diazodisulfone sowie Sulfonsäureester, insbesondere Ester aromatischer Sulfonsäuren, wie Toluolsulfonsäure, mit Hydroxyimiden, d.h. Verbindungen wie N-Sulfonyloxy-maleinimide, -phthalimide und -naphthalimide. Verbindungen wie N-Sulfonyloxy-maleinimide können auch in das Polymer eingebaut werden, wodurch einer möglichen Entmischung von Polymer und Säurebildner vorgebeugt wird. Der Säurebildner kann auch kovalent gebundenes Jod enthalten.

Als Pufferverbindung eignen sich vorteilhaft quartäre Ammoniumverbindungen mit einem Sulfonatanion (R-SO₃⁻). Quartären Ammoniumverbindungen, d.h. organischen Ammoniumverbindungen mit einem quartären Stickstoffatom, liegen tertiäre Amine zugrunde. Im vorliegenden Fall sind dies beispielsweise Trimethylamin, Dimethylethylamin, Methyldiethylamin, Triethylamin, N,N-Dimethylanilin und Pyridin. Das Sulfonatanion leitet sich vorzugsweise von der Benzol-, Toluol-, Naphthalin-, Cyclohexan- oder Camphersulfonsäure ab. Derartige Pufferverbindungen sind beispielsweise Salze von Toluolsulfonsäuren mit tertiären Aminen, wie Tetramethylammonium- und Tetraethylammonium-tosylat.

Bevorzugte Sensibilisatoren sind - für die Belichtung - Carbonsäuren oder Ester von polycyclischen aromatischen Kohlenwasserstoffen, d.h. aromatischen Verbindungen mit kondensierten Ringsystemen, oder Schutzgruppen aufweisende Verbindungen mit phenolischen OH-Gruppen und - für die Elektronenbestrahlung - aromatische Verbindungen mit kovalent gebundenen Atomen hoher Ordnungszahl, wie Jod. Vorteilhaft weist der Sensibilisator eine geschützte basenlösliche Gruppe auf, die - in den belichteten bzw. bestrahlten Bereichen - säurekatalysiert abgespalten wird, wodurch der Sensibilisator in basischen Entwicklern löslich wird. Der Sensibilisator kann auch in das Polymer eingebaut sein; in diesem Fall ist eine basenlösliche Gruppe nicht erforderlich.

Für die optische Belichtung eignen sich vorteilhaft folgende aromatische Verbindungen als Sensibilisator: Fluoren-9-carbonsäure, Fluoren-9-carbonsäure-tert.-butylester, Methoxynaphthylpropionsäure-tert.-butylester und Xanthen-9-carbonsäure-tert.-butylester sowie Tetrahydropyranyl- oder tert.-Butoxycarbonyloxy-Schutzgruppen aufweisendes Bisphenol A oder Dihydroxynaphthalin. Für das Elektronenstrahlschreiben sind als Sensibilisator vorteilhaft aromatische Verbindungen mit kovalent gebundenem Jod geeignet. Dies sind beispielsweise niedermolekulare Verbindungen wie Jodanisol und Trijodphenol.

Als Lösemittel dienen an sich bekannte Resistlösemittel. Vorzugsweise ist das Lösemittel Methoxypropylacetat oder ein Gemisch aus γ-Butyrolacton und Cyclohexanon, insbesondere im Volumenverhältnis von etwa 1:2. Weitere geeignete Lösemittel sind beispielsweise Cyclopentanon und Cyclohexanon oder Ethylenglykol- bzw. Diethylenglykolether, gegebenenfalls im Gemisch mit Dibenzylether.

Der Resist nach der Erfindung weist im allgemeinen folgende Zusammensetzung auf, wobei sich die einzelnen Anteile zu 100 % ergänzen: 5 bis 9 Masse-% Polymer, 0,2 bis 1 Masse-% Säurebildner, 0,1 bis 0,5 Masse-% Pufferverbindung und 85 bis 94 Masse-% Lösemittel sowie gegebenenfalls 0,2 bis 1 Masse-% Sensibilisator. Dabei beträgt das Masseverhältnis von Säurebildner zu Sensibilisator vorzugsweise etwa 1:1.

Der Resist kann sowohl in Einlagen- als auch in Zweilagenprozessen eingesetzt werden. Aufgrund des besseren Auflösungsvermögens und zur Eliminierung von Substratreflexionen sind aber Zweilagenprozesse bevorzugt. Der Resist kann mit UV-Strahlung einer Wellenlänge ≤ 300 nm (DUV) belichtet oder mit Elektronen mit einer Beschleunigungsspannung im Bereich von etwa 5 bis 50 kV bestrahlt werden.

Anhand von Ausführungsbeispielen soll die Erfindung noch näher erläutert werden (MT = Masseteile).

### Beispiel 1 (Belichtung im DUV-Bereich)

Es wird eine Resistlösung folgender Zusammensetzung verwendet: 7,5 MT eines Copolymers aus Maleinsäureanhydrid und Methacrylsäure-tert.-butylester (im Molverhältnis 50:50) mit einem Molgewicht von ca. 3000 g/mol (hergestellt durch radikalische Polymerisation), 1 MT des Esters von N-Hydroxyphthalimid mit Toluolsulfonsäure (als Säurebildner), 0,5 MT Tetraethylammonium-tosylat (als Pufferverbindung), 1 MT Fluoren-9-carbonsäure (als Sensibilisator) und 90 MT 1-Methoxy-2-propyl-acetat (als Lösemittel). Die Resistlösung wird auf eine Siliziumscheibe aufgeschleudert (Umdrehungszahl: 3000 min⁻¹), welche mit einer 1,5 µm dicken ausgeheizten Novolakschicht (220°C/30 min im Umluftofen) als Bottomresist versehen ist; dann wird auf einer Heizplatte vorgetrocknet (120°C/60 s). Die Schichtdicke des dabei erhaltenen Topresists beträgt 250 nm. Anschließend wird der Topresist durch eine Graukeilmaske (Multi density resolution target / Ditric Optics) auf einem Mask Aligner mit Vakuumkontaktbelichtung (MJB 3 / Süss KG mit UV-M-Interferenzfilter / Schott) mit UV-Strahlung bei 249 nm belichtet und - nach einer Standzeit T - auf einer Heizplatte bei 100°C/120 s getrocknet (PEB). Dabei werden, katalysiert durch die photolytisch gebildete Säure, die tert.-Butylestergruppen abgespalten. Durch Entwickeln (90 s, Puddle-Anlage / Hamatech) mit einem wäßrig-alkalischen Entwickler (NMD-W 2,38 % / Tokyo Ohka) wird ein positives Abbild der Maske erhalten.

Da die Maske Bereiche mit verschiedenen Transmissionsgraden aufweist, kann die Lichtdosis bestimmt werden (Dp(0)-Dosis), bei welcher der Resist gerade vollständig entwickelt ist, d.h. keine Restschichtdicke mehr gemessen wird. Die auf diese Weise ermittelte Dp(0)-Dosis (8 mJ/cm²) erweist sich im Rahmen der Meßgenauigkeit (± 1 mJ/cm²) als unabhängig von einer Standzeit T von 24 h. Die Dp(0)-Dosis korreliert umgekehrt proportional mit der im Resist nach der Entwicklung gemessenen Linien- bzw. Grabenbreite (CD) bei Projektionsbelichtung (Waferstepper) mit einer vorgegebenen Belichtungsdosis. Dabei bewirkt eine Dosisvariation von 20 % eine Variation von maximal 0,1 µm bei den Linien und Gräben. Daraus ergibt sich, daß eine im Rahmen der Fehlergrenzen mögliche Schwankung der Dp(0)-Dosis von maximal 11 % keine nennenswerte Schwankung der Linienbreite hervorrufen kann, wie sie häufig beschrieben wird.

Nach der Naßentwicklung wird der Topresist 120 s mit einer Silylierungslösung in Form einer 2 %igen Lösung eines Diaminopropyl-dimethylsiloxan-oligomers (Tegomer A-Si 1020 /Goldschmidt) in einem Gemisch aus Ethanol und 2-Propanol (Volumenverhältnis 1:2) behandelt; dabei nimmt die Schichtdicke des Resists um 95 nm zu. Anschließend wird 20 s mit reinem 2-Propanol gespült, und dann wird die Siliziumscheibe in eine Plasmaätzanlage (MIE 720 / Material Research Corporation) gebracht. Bei einer RF-Leistung von 900 W (Biasspannung: 45 V) und einem Sauerstofffluß von 30 sccm (Druck: 3 µbar) werden die Strukturen in den Bottomresist übertragen; die Ätzzeit beträgt 45 s (35 % Überätzung).

### Beispiel 2 (Elektronenstrahlschreiben)

Es wird eine Resistlösung folgender Zusammensetzung verwendet: 8,9 MT eines Terpolymers aus Maleinsäureanhydrid, Methacrylsäure-tert.-butylester und Methacrylsäure (im Molverhältnis 50:40:10) mit einem Molgewicht von ca. 3000 g/mol (hergestellt durch radikalische Polymerisation), 1 MT des Esters von N-Hydroxyphthalimid mit p-Jodbenzolsulfonsäure (als Säurebildner), 0,1 MT Tetraethylammonium-tosylat (als Pufferverbindung), 1 MT Fluoren-9-carbonsäure (als Sensibilisator) und 90 MT 1-Methoxy-2-propyl-acetat (als Lösemittel). Die Resistlösung wird auf eine Siliziumscheibe aufgeschleudert (Umdrehungszahl: 3000 min⁻¹), welche mit einer 0,5 µm dicken ausgeheizten Novolakschicht (220°C/45 min im Umluftofen) als Bottomresist versehen ist; dann wird auf einer Heizplatte vorgetrocknet (120°C/60 s). Die Schichtdicke des dabei erhaltenen Topresists beträgt 250 nm. Anschließend wird der Resist mittels eines Elektronenstrahlschreibers (HL 700 /Hitachi) bei einer Beschleunigungsspannung von 30 kV mit Elektronen bestrahlt und - nach einer Standzeit T - auf einer Heizplatte bei 130°C/120 s getrocknet (PEB). Dabei werden, katalysiert durch die photolytisch gebildete Säure, die tert.-Butylestergruppen abgespalten. Durch Entwickeln (40 s, Puddle-Anlage / Hamatech) mit einem wäßrig-alkalischen Entwickler (NMD-W 1,19 % / Tokyo Ohka mit einem Zusatz von 1 % Methylbenzylamin) wird die geschriebene Struktur erhalten.

Durch das Elektronenstrahlschreiben können verschiedene Bereiche direkt mit unterschiedlichen Dosen bestrahlt werden, und so kann die Dp(0)-Dosis bestimmt werden. Die auf diese Weise ermittelte Dp(0)-Dosis (7 µC/cm²) erweist sich im Rahmen der Meßgenauigkeit (± 1 µC/cm²) als unabhängig von einer Standzeit T von 24 h. Die Dp(0)-Dosis korreliert umgekehrt proportional mit der im Resist nach der Entwicklung gemessenen Linien- bzw. Grabenbreite (CD) bei Elektronenbelichtung mit einer vorgegebenen Dosis. Dabei bewirkt eine Dosisvariation von 20 % eine Variation von maximal 0,1 µm bei den Linien und Gräben. Daraus ergibt sich, daß eine im Rahmen der Fehlergrenzen mögliche Schwankung der Dp(0)-Dosis von maximal 11 % keine nennenswerte Schwankung der Linienbreite hervorrufen kann, wie sie häufig beschrieben wird.

Nach der Naßentwicklung wird in entsprechender Weise verfahren wie bei Beispiel 1.

Anstelle des vorstehend genannten Resists kann auch der Resist entsprechend Beispiel 1 eingesetzt werden. Der Puffereffekt ist dabei gleichermaßen gegeben.

## Patentansprüche

1. Chemisch verstärkter Resist, enthaltend
- ein Polymer mit Carbonsäureanhydridgruppen und tert.-Butylester-, tert.-Butoxycarbonyloxy-, Tetrahydrofuranyloder Tetrahydropyranylgruppen,
- eine photoreaktive Verbindung, die bei Belichtung oder Elektronenbestrahlung eine Sulfonsäure mit einem pKₐ-Wert > 0,5 freisetzt (Säurebildner),
- eine Pufferverbindung, die mit der Sulfonsäure eine reversible chemische Reaktion eingehen kann, und
- ein Lösemittel.

2. Resist nach Anspruch 1, **dadurch gekennzeichnet, daß** er zusätzlich einen Sensibilisator enthält, der eine Erhöhung der Licht- bzw. Elektronenausbeute bewirkt.

3. Resist nach Anspruch 2, **dadurch gekennzeichnet, daß** das Masseverhältnis von Säurebildner zu Sensibilisator etwa 1:1 beträgt.

4. Resist nach einem der Ansprüche 1 bis 3, **dadurch gekennzeichnet, daß** der Säurebildner ein Sulfonat, Disulfon, Diazodisulfon oder Sulfonsäureester ist.

5. Resist nach einem oder mehreren der Ansprüche 1 bis 4, **dadurch gekennzeichnet, daß** die Pufferverbindung eine quartäre Ammoniumverbindung mit einem Sulfonatanion ist.

6. Resist nach einem oder mehreren der Ansprüche 1 bis 5, **dadurch gekennzeichnet, daß** das Lösemittel Methoxypropylacetat oder ein Gemisch aus γ-Butyrolacton und Cyclohexanon ist.

7. Resist nach einem oder mehreren der Ansprüche 2 bis 6, **dadurch gekennzeichnet, daß** der Sensibilisator eine Carbonsäure oder ein Ester eines polycyclischen aromatischen Kohlenwasserstoffes ist oder eine Schutzgruppen aufweisende Verbindung mit phenolischen OH-Gruppen.

8. Resist nach einem oder mehreren der Ansprüche 2 bis 6, **dadurch gekennzeichnet, daß** der Sensibilisator eine aromatische Verbindung mit kovalent gebundenem Jod ist.

## Claims

1. Chemically amplified resist comprising
- a polymer containing carboxylic anhydride groups and tert-butyl ester, tert-butoxycarbonyloxy, tetrahydrofuranyl or tetrahydropyranyl groups,
- a photoreactive compound which on exposure to light or electron beams liberates a sulphonic acid having a pKₐ > 0.5 (acid generator),
- a buffer compound which is able to undergo a reversible chemical reaction with the sulphonic acid, and
- a solvent.

2. Resist according to Claim 1, **characterized in that** it further comprises a sensitizer which has the effect of increasing the light yield or electron yield.

3. Resist according to Claim 2, **characterized in that** the mass ratio of acid generator to sensitizer is about 1:1.

4. Resist according to one of Claims 1 to 3, **characterized in that** the acid generator is a sulphonate, disulphone, diazo disulphone or sulphonic ester.

5. Resist according to one or more of Claims 1 to 4, **characterized in that** the buffer compound is a quaternary ammonium compound with a sulphonate anion.

6. Resist according to one or more of Claims 1 to 5, **characterized in that** the solvent is methoxypropyl acetate or a mixture of γ-butyrolactone and cyclohexanone.

7. Resist according to one or more of Claims 2 to 6, **characterized in that** the sensitizer is a carboxylic acid or an ester of a polycyclic aromatic hydrocarbon or is a compound which contains protective groups and phenolic OH groups.

8. Resist according to one or more of Claims 2 to 6, **characterized in that** the sensitizer is an aromatic compound containing covalently bonded iodine.

## Revendications

1. Réserve amplifiée chimiquement, comprenant
- un polymère ayant des groupes anhydride d'acide carboxylique et des groupes ester butylique tertiaire, butoxycarbonyloxy tertiaire, tétrahydrofuranyle ou tétrahydropyranyle,
- un composé photo-réactif qui, par exposition à de la lumière ou lorsqu'il est soumis à un faisceau d'électrons, dégage un acide sulfonique ayant une valeur de pKₐ > 0,5 (agent acidifiant),
- un composé tampon, qui peut avoir avec l'acide sulfonique une réaction chimique réversible, et
- un solvant.

2. Réserve suivant la revendication 1, **caractérisée en ce qu'**elle comprend en outre un sensibilisateur qui provoque une augmentation du rendement lumineux ou électronique.

3. Réserve suivant la revendication 2, **caractérisée en ce que** le rapport en poids de l'agent acidifiant ou sensibilisateur est d'environ 1:1.

4. Réserve suivant l'une des revendications 1 à 3, **caractérisée en ce que** l'agent acidifiant est un sulfonate, une disulfone, une diazodisulfone ou un ester de l'acide sulfonique.

5. Réserve suivant l'une ou plusieurs des revendications 1 à 4, **caractérisée en ce que** le composé tampon est un composé d'ammonium quaternaire ayant un anion sulfonate.

6. Réserve suivant l'une ou plusieurs des revendications 1 à 5, **caractérisée en ce que** le solvant est l'acétate de méthoxypropyle ou un mélange de γ-butyrolactone et de cyclohexanone.

7. Réserve suivant l'une ou plusieurs des revendications 2 à 6, **caractérisée en ce que** le sensibilisateur est un acide carboxylique ou un ester d'un hydrocarbure aromatique polycyclique ou un composé à groupes OH phénoliques ayant des groupes de protection.

8. Réserve suivant l'une ou plusieurs des revendications 2 à 6, **caractérisée en ce que** le sensibilisateur est un composé aromatique ayant de l'iode lié par covalence.
